# EUROPEAN PATENT APPLICATION

(11) **EP 2 811 642 A1**
(43) Date of publication of application: **10.12.2014**
(21) Application number: 12867525.3
(22) Date of filing: 31.01.2012
(51) Int. Cl.: H02M 7/48

(54) **POWER CONVERTER AND METHOD FOR MANUFACTURING POWER CONVERTER**

(71) Applicant: Kabushiki Kaisha Yaskawa Denki, Kitakyushu-shi, Fukuoka 806-0004 (JP)
(72) Inventor: HONDA, Tomokazu, Kitakyushu-shi Fukuoka 806-0004 (JP); SASAKI, Akira, Kitakyushu-shi Fukuoka 806-0004 (JP); KOGUMA, Kiyonori, Kitakyushu-shi Fukuoka 806-0004 (JP); TAKENAKA, Kunihiro, Kitakyushu-shi Fukuoka 806-0004 (JP); UJITA, Yu, Kitakyushu-shi Fukuoka 806-0004 (JP); NODA, Yuji, Kitakyushu-shi Fukuoka 806-0004 (JP)
(74) Representative: Viering, Jentschura & Partner Patent- und Rechtsanwälte
(86) International application number: PCT/JP2012/052119
(87) International publication number: WO 2013/114565

(57) **Abstract**

A power converter (100, 100a, 100b, 100c) includes a switch element (11a, 11b, 11c, 12a, 12b, 12c), a snubber capacitor (10a, 10b, 10c), and a connection conductor (31, 32) configured to connect the switch element and the snubber capacitor to each other, and at least a part of the connection conductor is arranged to be held between the snubber capacitor and an electrode of the switch element.

## Description

### Technical Field

The present invention relates to a power converter and a method for manufacturing a power converter, and more particularly, it relates to a power converter including a switch element and a snubber capacitor and a method for manufacturing the power converter.

### Background Art

In general, a power converter including a switch element and a snubber capacitor is known. Such a power converter is disclosed in Japanese Patent Laying-Open No. 2011-067045, for example.

In the aforementioned Japanese Patent Laying-Open No. 2011-067045, there is disclosed an inverter device (power converter) including a MOSFET (switch element) having an electrode and a snubber capacitor. This inverter device is provided with a metal substrate having an upper surface on which the MOSFET is arranged and a dielectric substrate having a lower surface on which the snubber capacitor is arranged, and the upper surface of the metal substrate and the lower surface of the dielectric substrate are opposed to each other. On the upper surface of the metal substrate and the lower surface of the dielectric substrate, wiring patterns are provided. The wiring patterns provided on the upper surface of the metal substrate and the lower surface of the dielectric substrate are electrically connected to the electrode of the MOSFET and the snubber capacitor. This inverter device is provided with a plate-like wiring portion (connection conductor) configured to electrically connect the wiring pattern provided on the upper surface of the metal substrate and the wiring pattern provided on the lower surface of the dielectric substrate to each other. Thus, the snubber capacitor and the MOSFET are electrically connected to each other through three wiring portions (conductors) of the wiring pattern provided on the upper surface of the metal substrate, the plate-like wiring portion, and the wiring pattern provided on the lower surface of the dielectric substrate.

### Prior Art

### Patent Document

Patent Document 1: Japanese Patent Laying-Open No. 2011-067045

### Summary of the Invention

### Problem to be Solved by the Invention

Generally, in the power converter including the switch element and the snubber capacitor, a wiring inductance between the snubber capacitor and the electrode of the switch element is preferably reduced in order to suppress an increase in a surge voltage.

However, in the inverter device (power converter) disclosed in the aforementioned Japanese Patent Laying-Open No. 2011-067045, the snubber capacitor and the MOSFET (switch element) are electrically connected to each other through the three conductors, so that a conduction path between the snubber capacitor and the MOSFET (switch element) is increased in length. Therefore, there is such a problem that the wiring inductance between the snubber capacitor and the MOSFET (switch element) is increased.

The present invention has been proposed in order to solve the aforementioned problem, and an object of the present invention is to provide a power converter capable of reducing a wiring inductance between the snubber capacitor and the switch element and a method for manufacturing the power converter.

### Means for Solving the Problem

In order to attain the aforementioned object, a power converter according to a first aspect of the present invention includes a switch element having an electrode, a snubber capacitor connected to the electrode of the switch element, and a connection conductor configured to connect the electrode of the switch element and the snubber capacitor to each other, and at least a part of the connection conductor is arranged to be held between the snubber capacitor and the electrode of the switch element.

In the power converter according to the first aspect of the present invention, as hereinabove described, at least the part of the connection conductor is arranged to be held between the snubber capacitor and the electrode of the switch element. Thus, the snubber capacitor and the switch element are electrically connected to each other through the single conductor (connection conductor), and hence a conduction path between the snubber capacitor and the switch element can be reduced in length. Consequently, a wiring inductance between the snubber capacitor and the switch element can be reduced.

A method for manufacturing a power converter according to a second aspect of the present invention is a method for manufacturing a power converter including a switch element having an electrode and a snubber capacitor and includes steps of connecting the electrode of the switch element to the rear surface side of a connection conductor and connecting the snubber capacitor to the front surface side of the connection conductor such that at least a part of the connection conductor is held between the snubber capacitor and the electrode of the switch element.

In the method for manufacturing a power converter according to the second aspect of the present invention, as hereinabove described, at least the part of the connection conductor is arranged to be held between the snubber capacitor and the electrode of the switch element. Thus, the snubber capacitor and the switch element are electrically connected to each other through the single conductor (connection conductor), and hence a conduction path between the snubber capacitor and the switch element can be reduced in length. Consequently, the method for manufacturing a power converter capable of reducing a wiring inductance between the snubber capacitor and the switch element can be provided.

### Effects of the Invention

According to the present invention, as hereinabove described, the wiring inductance between the snubber capacitor and the switch element can be reduced.

### Brief Description of the Drawings

[Fig. 1] A circuit diagram of a three-phase inverter device including a power module according to a first embodiment of the present invention.
[Fig. 2] A diagram of the power module according to the first embodiment of the present invention as viewed from the side.
[Fig. 3] A diagram of the power module shown in Fig. 2 as viewed from above.
[Fig. 4] A diagram of a substrate of the power module shown in Fig. 2 as viewed from below.
[Fig. 5] A diagram of the substrate shown in Fig. 4 as viewed from above.
[Fig. 6] A diagram of the upper surface of the substrate shown in Fig. 5 mounted with a first switch element and a second switch element as viewed from above.
[Fig. 7] A diagram showing a state where connection conductors are arranged on the front surface side of the first switch element and the rear surface side of the second switch element shown in Fig. 6 as viewed from above.
[Fig. 8] A diagram of a power module according to a second embodiment of the present invention as viewed from the side.
[Fig. 9] A diagram of the power module shown in Fig. 8 as viewed from above.
[Fig. 10] A diagram of a first substrate of the power module shown in Fig. 9 as viewed from below.
[Fig. 11] A diagram of the first substrate shown in Fig. 10 as viewed from above.
[Fig. 12] A diagram of the upper surface of the first substrate shown in Figs. 10 and 11 mounted with a first switch element as viewed from the side.
[Fig. 13] A diagram of a second substrate of the power module shown in Fig. 9 as viewed from above.
[Fig. 14] A diagram of the second substrate shown in Fig. 13 as viewed from below.
[Fig. 15] A diagram of the lower surface of the second substrate shown in Figs. 13 and 14 mounted with a second switch element as viewed from the side.
[Fig. 16] A diagram for illustrating a process for bonding the first substrate shown in Fig. 12 and the second substrate shown in Fig. 13 to each other.
[Fig. 17] A diagram of a power module according to a third embodiment of the present invention as viewed from the side.
[Fig. 18] A diagram of the power module shown in Fig. 17 as viewed from above.
[Fig. 19] A diagram of a power module according to a fourth embodiment of the present invention as viewed from above.
[Fig. 20] A diagram of the power module shown in Fig. 19 as viewed from the side.
[Fig. 21] A diagram of a power module according to a modification of the first embodiment of the present invention as viewed from above.
[Fig. 22] A diagram of a power module according to a modification of the second embodiment of the present invention as viewed from above.
[Fig. 23] A diagram of a power module according to a modification of the third embodiment of the present invention as viewed from the side.

### Modes for Carrying Out the Invention

Embodiments of the present invention are hereinafter described on the basis of the drawings.

### (First Embodiment)

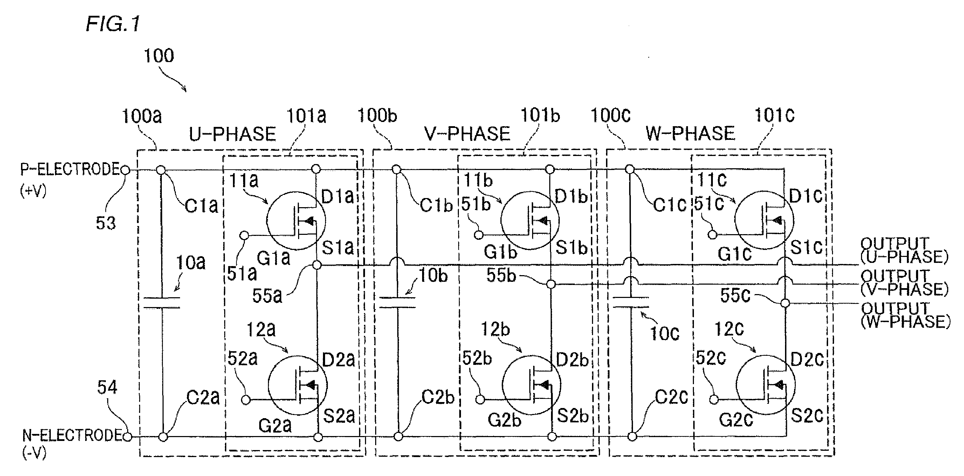

The structure of a three-phase inverter device 100 including power modules 100a, 100b, and 100c according to a first embodiment is now described with reference to Fig. 1. The power modules 100a to 100c are examples of the "power converter" in the present invention. The three-phase inverter device 100 is an example of the "power converter" in the present invention or the "three-phase inverter circuit" in the present invention.

As shown in Fig. 1, the three power modules 100a, 100b, and 100c performing U-phase, V-phase, and W-phase power conversion, respectively, are electrically connected in parallel to each other, whereby the three-phase inverter device 100 is configured. These three power modules 100a to 100c are provided as separate devices and are connected to each other by unshown wires or the like formed of metal wires.

The power modules 100a, 100b, and 100c include half-bridge circuits 101a, 101b, and 101c configured to perform U-phase, V-phase, and W-phase power conversion, respectively and snubber capacitors 10a, 10b, and 10c electrically connected in parallel to the half-bridge circuits 101a, 101b, and 101c, respectively. Each of the half-bridge circuits 101a, 101b, and 101c is configured to include two switch elements (a first switch element 11a and a second switch element 12a, a first switch element 11b and a second switch element 12b, or a first switch element 11c and a second switch element 12c) electrically connected in series with each other. The first switch elements 11a, 11b, and 11c and the second switch elements 12a, 12b, and 12c are examples of the "power conversion semiconductor element" in the present invention.

Each of the first switch elements 11a, 11b, and 11c is constituted by a MOSFET (field-effect transistor) having three electrodes (a gate electrode G1a, G1b, or G1c, a source electrode S1a, S1b, or S1c, and a drain electrode D1a, D1b, or D1c). Each of the second switch elements 12a, 12b, and 12c is also constituted by a MOSFET having three electrodes (a gate electrode G2a, G2b, or G2c, a source electrode S2a, S2b, or S2c, and a drain electrode D2a, D2b, or D2c).

The first switch elements 11a, 11b, and 11c and the second switch elements 12a, 12b, and 12c are configured to perform switching on the basis of control signals externally input through control terminals 51a, 51b, and 51c and control terminals 52a, 52b, and 52c, respectively, to convert direct-current power input through input terminals 53 and 54 into three-phase (U-phase, V-phase, and W-phase) alternating-current power. Furthermore, the first switch elements 11a, 11b, and 11c and the second switch elements 12a, 12b, and 12c are configured to output the alternating-current power obtained by the aforementioned conversion to an external portion through output terminals 55a, 55b, and 55c. The input terminals 53 and 54 are connected to a P-electrode (+V) and an N-electrode (-V) of an unshown direct-current power supply, respectively. The output terminals 55a, 55b, and 55c are connected to respective unshown motors or the like.

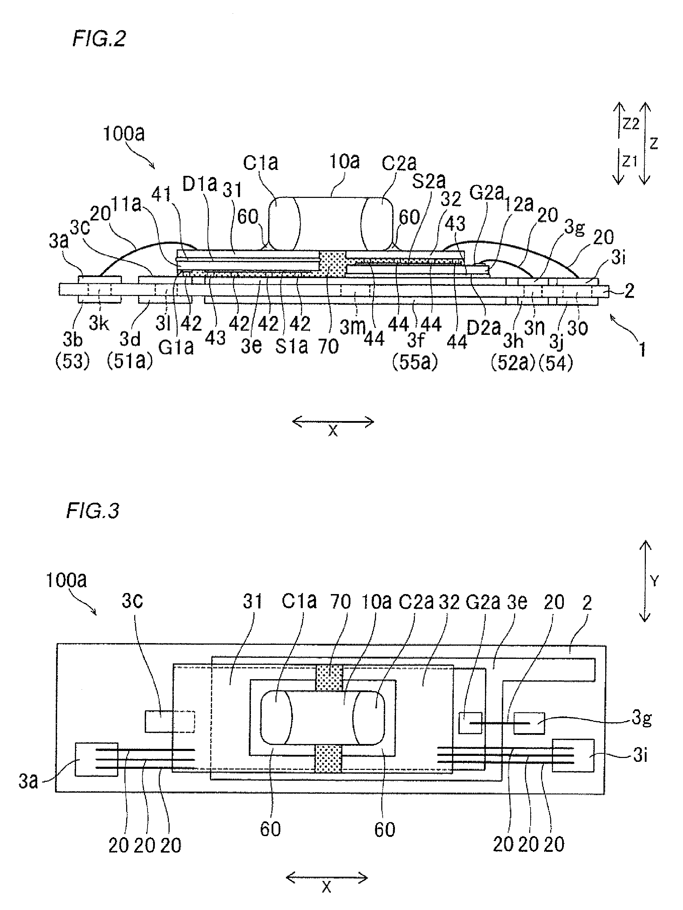

The detailed structure of the power modules 100a, 100b, and 100c according to the first embodiment is now described with reference to Figs. 2 and 3. The power modules 100a, 100b, and 100c have substantially the same structure, and hence only the power module 100a including the two switch elements (the first switch element 11a and the second switch element 12a) and the snubber capacitor 10a is described below.

As shown in Figs. 2 and 3, the power module 100a includes a substrate 1, the two switch elements (the first switch element 11a and the second switch element 12a), two connection conductors 31 and 32, and the snubber capacitor 10a. The substrate 1 is an example of the "first substrate" in the present invention. The connection conductors 31 and 32 are examples of the "first connection conductor" and the "second connection conductor" in the present invention, respectively.

The substrate 1 is configured to include an insulating plate 2 and ten conductive patterns 3a, 3b, 3c, 3d, 3e, 3f, 3g, 3h, 3i, and 3j provided on the front surface (upper surface: surface along an arrow Z2) and the rear surface (lower surface: surface along arrow Z1) of the insulating plate 2. The insulating plate 2 is made of an insulator such as ceramic in the form of a flat plate. The conductive patterns 3a to 3j each are made of a conductor of copper, gold, silver, aluminum, or alloy containing those in the form of a flat plate.

The conductive patterns 3a, 3c, 3e, 3g, and 3i and the conductive patterns 3b, 3d, 3f, 3h, and 3j are electrically connected to each other through columnar conductors 3k, 31, 3m, 3n, and 3o provided to pass through the insulating plate 2 from the upper surface (the surface along arrow Z2) to the lower surface (the surface along arrow Z1), respectively. The conductive pattern 3e is an example of the "first conductive pattern" in the present invention. The conductive pattern 3c is an example of the "second conductive pattern" in the present invention, and the conductive pattern 3d is an example of the "third conductive pattern" in the present invention. The conductive patterns 3a and 3i are examples of the "fourth conductive pattern" in the present invention, and the conductive patterns 3b and 3j are examples of the "fifth conductive pattern" in the present invention. The conductive patterns 3a, 3c, 3e, 3g, and 3i and the conductive patterns 3b, 3d, 3f, 3h, and 3j, respectively, may be electrically connected to each other through hollow conductors like through vias, not the columnar conductors 3k, 31, 3m, 3n, and 3o.

The first switch element 11a and the second switch element 12a are aligned in a direction X on the front surface (upper surface: surface along arrow Z2) of the substrate 1. In the following description, a surface provided with the drain electrode D1a (D2a) of the first switch element 11a (second switch element 12a) is set to the front surface of the first switch element 11a (second switch element 12a), and a surface provided with the gate electrode G1a (G2a) and the source electrode S1a (S2a) of the first switch element 11a (second switch element 12a) is set to the rear surface of the first switch element 11a (second switch element 12a).

According to the first embodiment, the first switch element 11a and the second switch element 12a are arranged such that the front surfaces and the rear surfaces thereof are oppositely oriented to each other, as shown in Fig. 2. Specifically, whereas the drain electrode D1a provided on the front surface side of the first switch element 11a is arranged on the rear surface (lower surface: surface along arrow Z1) side of the connection conductor 31, the drain electrode D2a provided on the front surface side of the second switch element 12a is arranged on the front surface (upper surface: surface along arrow Z2) side of the substrate 1. Whereas the gate electrode G1a and the source electrode S1a provided on the rear surface side of the first switch element 11a are arranged on the upper surface aside of the substrate 1, the gate electrode G2a and the source electrode S2a provided on the rear surface side of the second switch element 12a are arranged on the lower surface side of the connection conductor 32.

The drain electrode D1a of the first switch element 11a is bonded to the lower surface (surface along arrow Z1) of the connection conductor 31 through a bonding layer 41 made of solder or the like. The source electrode S1a and the gate electrode G1a of the first switch element 11a are bonded to the upper surfaces (surfaces along arrow Z2) of the conductive patterns 3c and 3e of the substrate 1 through a plurality of bumps 42. The drain electrode D1a of the second switch element 12a is bonded to the upper surface of the conductive pattern 3c of the substrate 1 through a bonding layer 43. The source electrode S2a of the second switch element 12a is bonded to the lower surface of the connection conductor 32 through a plurality of bumps 44. The gate electrode G2a of the second switch element 12a is electrically connected to the upper surface of the conductive pattern 3g of the substrate 10 through a wire 20 formed of a metal wire or the like. The source electrode S1a (gate electrode G1a) of the first switch element 11a and the conductive pattern 3c (3e) may be bonded to each other through a bonding layer made of solder or a bonding material other than solder, a plate-like conductor, or the like, not the bumps 42. Furthermore, the source electrode S1a (gate electrode G1a) of the first switch element 11a and the conductive pattern 3c (3e) may be bonded to each other only in a part of a region where the source electrode S1a (gate electrode G1a) of the first switch element 11a and the conductive pattern 3c (3e) are opposed to each other or may be bonded to each other in all of the region where the source electrode S1a (gate electrode G1a) of the first switch element 11a and the conductive pattern 3c (3e) are opposed to each other. Much the same is true on bonding between the source electrode S2a of the second switch element 12a and the connection conductor 32.

As hereinabove described, the connection conductors 31 and 32 are arranged above (on sides along arrow Z2 of) the first switch element 11a and the second switch element 12a, respectively. The connection conductors 31 and 32 each are made of a conductor of copper, gold, silver, aluminum, or alloy containing those in the form of a flat plate. The snubber capacitor 10a is arranged across the upper surfaces (surfaces along arrow Z2) of the two connection conductors 31 and 32. Specifically, one electrode C1a and the other electrode C2a of the snubber capacitor 10a are bonded to the upper surfaces of the connection conductors 31 and 32, respectively, through bonding materials 60 made of conductive adhesives such as solder or conductive paste (silver paste, for example). Thus, the connection conductors 31 and 32 are arranged to be held between the first switch element 11a and the snubber capacitor 10a and between the second switch element 12a and the snubber capacitor 10a, respectively.

The upper surface (surface along arrow Z2) of the connection conductor 31 and the upper surface of the conductive pattern 3a of the substrate 1 are electrically connected to each other through a wire 20. The upper surface of the connection conductor 32 and the upper surface of the conductive pattern 3i of the substrate 1 are electrically connected to each other through a wire 20. A region between the upper surface of the substrate 1 and the lower surfaces (surfaces along arrow Z1) of the connection conductors 31 and 32 and a region between the upper surface of the substrate 1 and the lower surface of the snubber capacitor 10a are filled with a sealing resin 70 made of an epoxy resin, a silicone resin, or the like.

Due to the aforementioned structure, according to the first embodiment, the conductive pattern 3b provided on the lower surface (surface along arrow Z1) side of the substrate 1 is electrically connected to the drain electrode D1a of the first switch element 11a through the columnar conductor 3k, the conductive pattern 3a, the wire 20, the connection conductor 31, and the bonding layer 41. Therefore, the conductive pattern 3b constitutes the input terminal 53 (see Fig. 1) connected to the P-electrode (+V) of the unshown direct-current power supply. The conductive pattern 3d is electrically connected to the gate electrode G1a of the first switch element 11a through the columnar conductor 31, the conductive pattern 3c, and the bumps 42. Therefore, the conductive pattern 3d constitutes the control terminal 51a (see Fig. 1) into which the control signal for switching the first switch element 11a is input. The control terminal 51a is an example of the "first control terminal" in the present invention.

Furthermore, the conductive pattern 3f provided on the lower surface (surface along arrow Z1) side of the substrate 1 is electrically connected to the source electrode S1a of the first switch element 11a through the columnar conductor 3m, the conductive pattern 3e, and the bumps 42 and is electrically connected to the drain electrode D2a of the second switch element 12a through the columnar conductor 3m, the conductive pattern 3e, and the bonding layer 43. Therefore, the conductive pattern 3f constitutes the output terminal 55a (see Fig. 1) connected to the unshown motor or the like.

In addition, the conductive pattern 3h provided on the lower surface (surface along arrow Z1) side of the substrate 1 is electrically connected to the gate electrode G2a of the second switch element 12a through the columnar conductor 3n, the conductive pattern 3g, and the wire 20. Therefore, the conductive pattern 3h constitutes the control terminal 52a (see Fig. 1) into which the control signal for switching the second switch element 12a is input. The conductive pattern 3j is electrically connected to the source electrode S2a of the second switch element 12a through the columnar conductor 3o, the conductive pattern 3i, the wire 20, the connection conductor 32, and the bumps 44. Therefore, the conductive pattern 3j constitutes the input terminal 54 (see Fig. 1) connected to the N-electrode (-V) of the unshown direct-current power supply.

A manufacturing process for the power module 100a according to the first embodiment is now described with reference to Figs. 2 to 7.

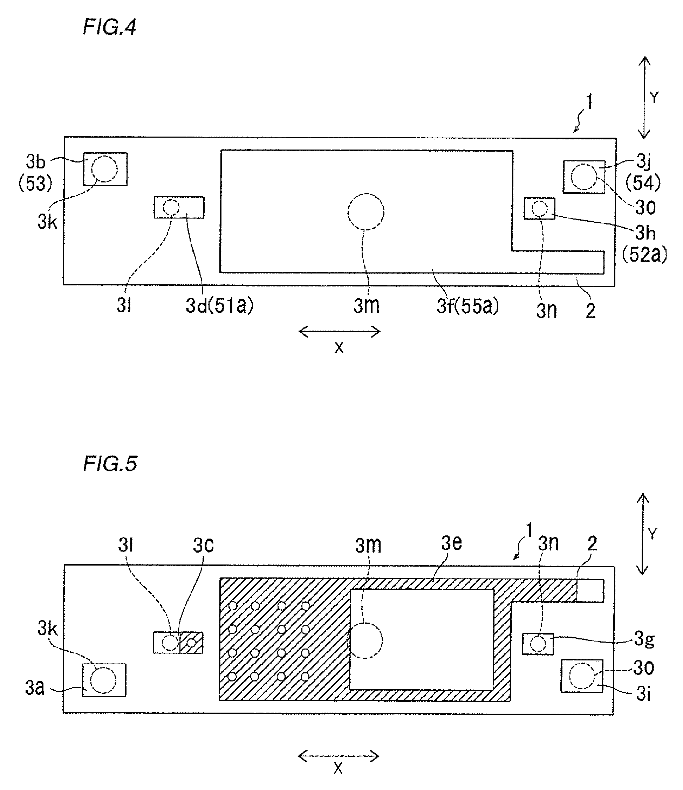

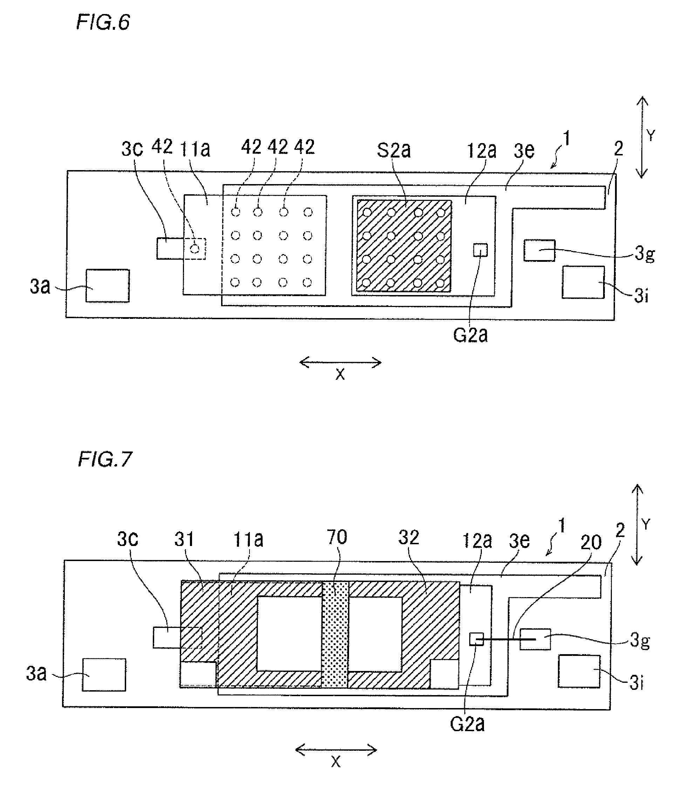

First, the substrate 1 provided with the ten conductive patterns 3a to 3j on the upper surface side (along arrow Z2) and lower surface side (along arrow Z1) of the insulating plate 2 is prepared, as shown in Figs. 4 and 5. Then, the upper surfaces (surfaces along arrow Z2) of the conductive patterns 3c and 3e of the substrate 1 and the gate electrode G1a and the source electrode S1a on the rear surface side of the first switch element 11a, respectively, are bonded to each other through the bumps 42 made of solder or the like, and the upper surface of the conductive pattern 3e and the drain electrode D2a on the front surface side of the second switch element 12a are bonded to each other through the bonding layer 43 made of solder or the like, as shown in Figs. 2 and 6.

Then, the connection conductors 31 and 32 in the form of a flat plate are arranged on the front surface side of the first switch element 11a and the rear surface side of the second switch element 12a, respectively, as shown in Figs. 2 and 7. Specifically, the drain electrode D1a on the front surface side of the first switch element 11a and the lower surface (surface along arrow Z1) of the connection conductor 31 are bonded to each other through the bonding layer 41, and the source electrode S2a and the gate electrode G2a on the rear surface side of the second switch element 12a and the lower surface of the connection conductor 31 are bonded to each other through the bumps 44. Then, the snubber capacitor 10a is bonded through the bonding materials 60 across the upper surfaces (surfaces along arrow Z2) of the connection conductors 31 and 32, as shown in Figs. 2 and 3.

At this time, the region between the upper surface (surface along arrow Z2) of the substrate 1 and the lower surfaces (surfaces along arrow Z1) of the connection conductors 31 and 32 and the region between the upper surface of the substrate 1 and the lower surface of the snubber capacitor 10a are filled with the sealing resin 70. The upper surfaces of the connection conductors 31 and 32 and the upper surfaces of the conductive patterns 3a and 3i of the substrate 1, respectively, are electrically connected to each other through the wires 20.

In the aforementioned bonding process employing the bonding layers 41 and 43, the bumps 42 and 44, and the bonding materials 60 made of solder or the like, a solder resist is preferably applied to prescribed areas (see portions shown by diagonal lines in Figs. 5 to 7, for example) in order to suppress spread of solder to unnecessary portions.

According to the first embodiment, as hereinabove described, the connection conductor 31 (32) is arranged to be held between the snubber capacitor 10a and the first switch element 11a (second switch element 12a). Thus, the snubber capacitor 10a and the first switch element 11a (second switch element 12a) are electrically connected to each other through the single conductor (connection conductor 31 (32)), and hence a conduction path between the snubber capacitor 10a and the first switch element 11a (second switch element 12a) can be reduced in length. Consequently, a wiring inductance between the snubber capacitor 10a and the first switch element 11a (second switch element 12a) can be reduced.

According to the first embodiment, as hereinabove described, the drain electrode D1a on the front surface side of the first switch element 11a is arranged on the side of the connection conductor 31, and the source electrode S2a on the rear surface side of the second switch element 12a is arranged on the side of the connection conductor 32. Thus, the snubber capacitor 10a and the drain electrode D1a on the front surface side of the first switch element 11a can be easily electrically connected to each other through the connection conductor 31, and the snubber capacitor 10a and the source electrode S2a on the rear surface side of the second switch element 12a can be easily electrically connected to each other through the connection conductor 32.

According to the first embodiment, as hereinabove described, the conductive pattern 3e configured to connect the source electrode S1a on the rear surface side of the first switch element 11a and the drain electrode D2a on the front surface side of the second switch element 12a to each other is provided on the upper surface (surface along arrow Z2) of the substrate 1 on which the first switch element 11a and the second switch element 12a are arranged. Thus, the source electrode S1a on the rear surface side of the first switch element 11a and the drain electrode D2a on the front surface side of the second switch element 12a can be easily electrically connected to each other through the conductive pattern 3e of the substrate 1.

According to the first embodiment, as hereinabove described, the connection conductors 31 and 32 are bonded to the snubber capacitor 10a through the bonding materials 60. Thus, the connection conductors 31 and 32 can be strongly bonded to the snubber capacitor 10a by the bonding materials 60.

According to the first embodiment, as hereinabove described, the region between the upper surface (surface along arrow Z2) of the substrate 1 and the lower surfaces (surfaces along arrow Z1) of the connection conductors 31 and 32 is filled with the sealing resin 70. Thus, the entry of extraneous material between the upper surface of the substrate 1 and the lower surfaces of the connection conductors 31 and 32 can be suppressed by the sealing resin 70, and the reliability of insulation can be improved.

According to the first embodiment, as hereinabove described, the connection conductors 31 and 32 are made of the conductor in the form of a flat plate. Furthermore, one electrode C1a and the other electrode C2a of the snubber capacitor 10a are connected to the upper surfaces (surfaces along arrow Z2) of the connection conductors 31 and 32, respectively, and the drain electrode D1a of the first switch element 11a and the source electrode S2a of the second switch element 12a are connected to the lower surfaces (surfaces along arrow Z1) of the connection conductors 31 and 32, respectively. Thus, the snubber capacitor 10a and the first switch element 11a and the second switch element 12a are bonded to the connection conductors 31 and 32 in the form of a flat plate, whereby bonding areas (plane areas) between the snubber capacitor 10a and the connection conductors 31 and 32 can be increased while bonding areas (plane areas) between the first switch element 11a and the connection conductor 31 and between the second switch element 12a and the connection conductor 32 can be increased. Consequently, bonding strength between the snubber capacitor 10a and the connection conductors 31 and 32 can be increased, and bonding strength between the first switch element 11a and the connection conductor 31 and between the second switch element 12a and the connection conductor 32 can be increased.

According to the first embodiment, as hereinabove described, the conductive patterns 3d and 3h, the conductive patterns 3b and 3j, and the conductive pattern 3f constituting the control terminals 51a and 52a, the input terminals 53 and 54, and the output terminal 55a, respectively, are provided on the lower surface (surface along arrow Z1) of the substrate 1. Thus, the control terminals 51a and 52a, the input terminals 53 and 54, and the output terminal 55a can be easily connected to external devices (the unshown direct-current power supply, the unshown motor, etc.), utilizing a region on the lower surface side of the substrate 1.

According to the first embodiment, as hereinabove described, the conductive pattern 3c is provided on the upper surface (surface along arrow Z2) of the substrate 1, and the conductive pattern 3d electrically connected to the conductive pattern 3c is provided on the lower surface (surface along arrow Z2) of the substrate 1. Furthermore, the conductive pattern 3c on the upper surface of the substrate 1 and the gate electrode G1a provided on the rear surface side of the first switch element 11a are connected to each other, and the conductive pattern 3d on the lower surface of the substrate 1 constitutes the control terminal 51a. Thus, the gate electrode G1a of the first switch element 11a and the control terminal 51a can be easily connected to each other, unlike the case where the gate electrode G1a of the first switch element 11a and the control terminal 51a into which the control signal is externally input are connected to each other by a wire or the like.

### (Second Embodiment)

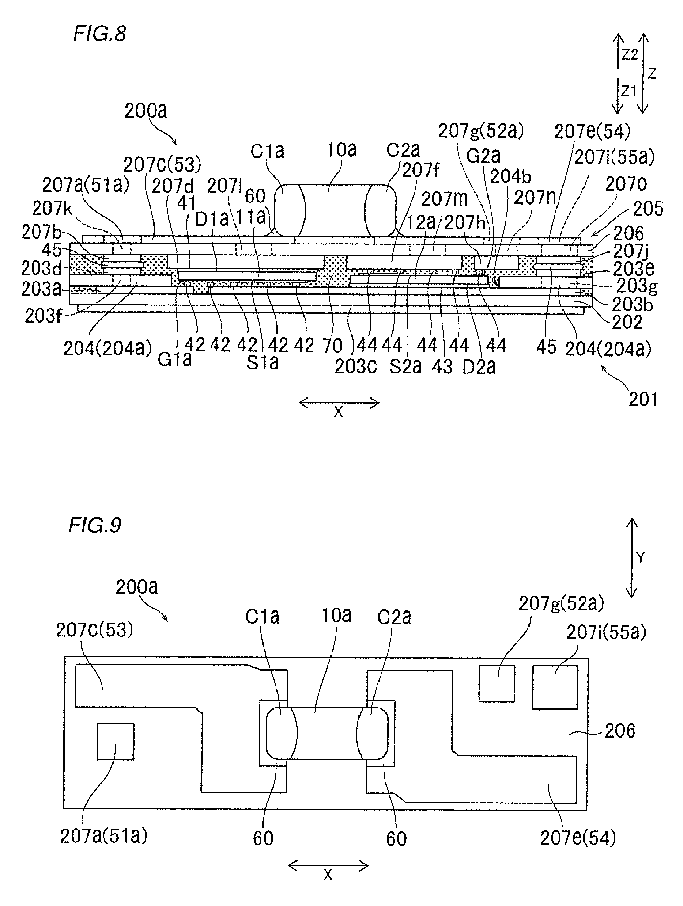

A power module 200a according to a second embodiment is now described with reference to Figs. 8 to 16. In this second embodiment, an example of arranging two switch elements (a first switch element 11a and a second switch element 12a) in a region (space) between two substrates (a first substrate 201 and a second substrate 205) arranged to be opposed to each other is described unlike the aforementioned first embodiment (see Fig. 2) in which the two switch elements (the first switch element 11a and the second switch element 12a) are arranged on the upper surface (surface along arrow Z2) of the single substrate 1. The power module 200a is an example of the "power converter" in the present invention.

First, the structure of the power module 200a according to the second embodiment is described with reference to Figs. 8 to 15. This power module 200a performs U-phase power conversion in a three-phase inverter device. In other words, also according to the second embodiment, two power modules (power modules performing V-phase and W-phase power conversion) having substantially the same structure as the power module 200a are provided separately from the power module 200a, similarly to the aforementioned first embodiment. Only the power module 200a performing U-phase power conversion is described below for simplification.

As shown in Fig. 8, the power module 200a includes the first substrate 201, the two switch elements (the first switch element 11a and the second switch element 12a), the second substrate 205, and a snubber capacitor 10a.

As shown in Figs. 8 and 10 to 12, the first substrate 201 is configured to include an insulating plate 202 in the form of a flat plate, conductive patterns 203a, 203b, and 203c provided on the upper surface (surface along arrow Z2) and lower surface (surface along arrow Z1) of the insulating plate 202, two insulating plates 204 provided to protrude from the upper surfaces of the conductive patterns 203a and 203b, and conductive patterns 203d and 203e provided on the upper surfaces of the two insulating plates 204. The insulating plates 202 and 204 each are made of an insulator such as ceramic. The conductive patterns 203a to 203e each are made of a conductor of copper, gold, silver, aluminum, or alloy containing those in the form of a flat plate.

The conductive pattern 203a and the conductive pattern 203d are electrically connected to each other through a columnar conductor 203f provided to pass through the insulating plate 204. Furthermore, the conductive pattern 203b and the conductive pattern 203e are electrically connected to each other through a columnar conductor 203g provided to pass through the insulating plate 204. The conductive pattern 203b is an example of the "first conductive pattern" in the present invention.

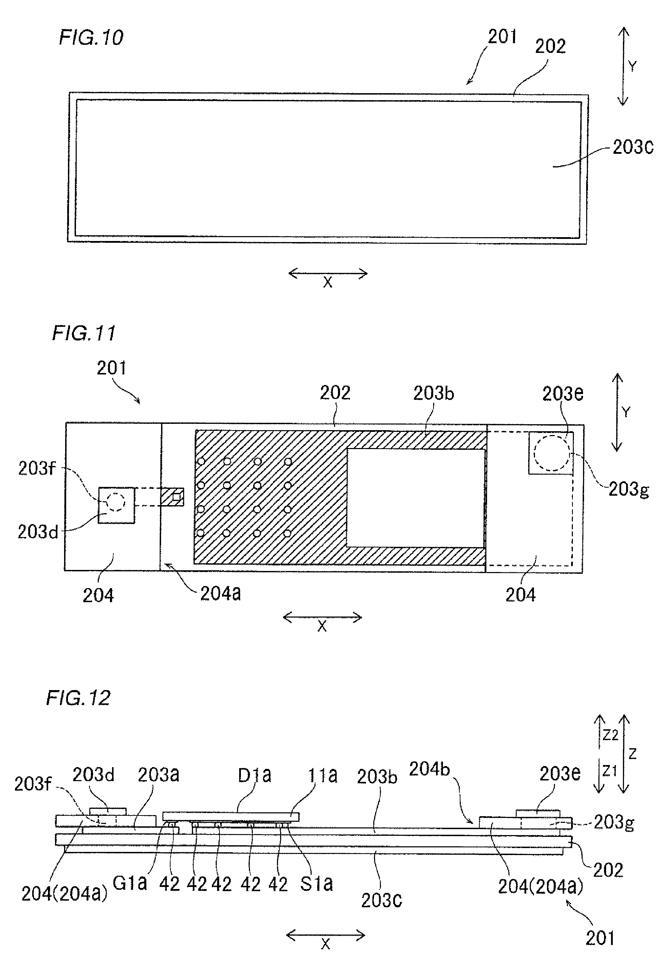

According to the second embodiment, the two insulating plates 204 arranged in the vicinity of both ends of the first substrate 201 in a direction X constitute two protruding portions 204a protruding upward (along arrow Z2) from the upper surface (surface along arrow Z2) of the first substrate 201, as shown in Figs. 8 and 12. A space formed by the inner surfaces of these two protruding portions 204a and the upper surface of the insulating plate 202 constitutes a recess portion 204b.

As shown in Fig. 8, the second substrate 205 is arranged above (on a side along arrow Z2 of) the first substrate 201. Specifically, the lower surface (surface along arrow Z1) of the second substrate 205 is bonded to the upper surfaces of the conductive patterns 203d and 203e provided on the upper surfaces (surfaces along arrow Z2) of the two insulating plates 204 (protruding portions 204a) through bonding layers 45 made of solder or the like.

As shown in Figs. 8 and 13 to 15, the second substrate 205 is configured to include an insulating plate 206 in the form of a flat plate and conductive patterns 207a, 207b, 207c, 207d, 207e, 207f, 207g, 207h, 207i, and 207j provided on the upper surface (surface along arrow Z2) and lower surface (surface along arrow Z1) of the insulating plate 206. The insulating plate 206 is made of an insulator such as ceramic. The conductive patterns 207a to 207i each are made of a conductor of copper, gold, silver, aluminum, or alloy containing those in the form of a flat plate.

The conductive patterns 207a, 207c, 207e, 207g, and 207i and the conductive patterns 207b, 207d, 207f, 207h, and 207j are electrically connected to each other through columnar conductors 207k, 2071, 207m, 207n, and 207o provided to pass through the insulating plate 2 from the upper surface (the surface along arrow Z2) to the lower surface (the surface along arrow Z1), respectively. The conductive patterns 207c and 207e are examples of the "sixth conductive pattern" in the present invention, and the conductive patterns 207d and 207f are examples of the "seventh conductive pattern" in the present invention. The conductive pattern 207g is an example of the "eighth conductive pattern" in the present invention, and the conductive pattern 207h is an example of the "ninth conductive pattern" in the present invention.

As shown in Fig. 8, the first switch element 11a and the second switch element 12a having the same structure as those according to the aforementioned first embodiment are aligned in the direction X in a region between the upper surface (surface along arrow Z2) of the first substrate 201 and the lower surface (surface along arrow Z1) of the second substrate 205 (a space in the aforementioned recess portion 204b formed by the inner surfaces of the insulating plates 204 and the conductive patterns 203d and 203e and the upper surface of the first substrate 201). Also according to this second embodiment, the first switch element 11a and the second switch element 12a are arranged such that the front surfaces and the rear surfaces thereof are oppositely oriented to each other, similarly to the aforementioned first embodiment.

In other words, a drain electrode D1a provided on the front surface side of the first switch element 11a is bonded to the lower surface (surface along arrow Z1) of the conductive pattern 207d of the second substrate 205 through a bonding layer 41 made of solder or the like. A source electrode S1a and a gate electrode G1a provided on the rear surface side of the first switch element 11a are bonded to the upper surfaces (surfaces along arrow Z2) of the conductive patterns 203a and 203b of the first substrate 201, respectively, through bumps 42 made of solder or the like.

A drain electrode D2a provided on the front surface side of the second switch element 12a is bonded to the upper surface (surface along arrow Z2) of the conductive pattern 203b of the first substrate 201 through a bonding layer 43. A source electrode S2a and a gate electrode G2a provided on the rear surface side of the second switch element 12a are bonded to the lower surfaces (surfaces along arrow Z1) of the conductive patterns 207f and 207h of the second substrate 205 through bumps 44, respectively.

As hereinabove described, the conductive patterns 207d and 207f of the second substrate 205 are arranged above (on sides along arrow Z2 of) the first switch element 11a and the second switch element 12a, respectively. As shown in Figs. 8 and 9, the snubber capacitor 10a is arranged across the upper surfaces (surfaces along arrow Z2) of the conductive patterns 207c and 207e of the second substrate 205. Specifically, one electrode C1a and the other electrode C2a of the snubber capacitor 10a are bonded to the upper surfaces of the conductive patterns 207c and 207e of the second substrate 205, respectively, through bonding materials 60 made of conductive adhesives such as solder or conductive paste (silver paste, for example). Thus, the conductive patterns 207c and 207d and the columnar conductor 2071 between the conductive patterns 207c and 207d are arranged to be held between the first switch element 11a and one electrode C1a of the snubber capacitor 10a. Similarly, the conductive patterns 207e and 207f and the columnar conductor 207m between the conductive patterns 207e and 207f are arranged to be held between the second switch element 12a and the other electrode C2a of the snubber capacitor 10a. The conductive patterns 207c and 207d and the columnar conductor 2071 are examples of the "first connection conductor" in the present invention. The conductive patterns 207e and 207f and the columnar conductor 207m are examples of the "second connection conductor" in the present invention.

Also according to this second embodiment, a space between the upper surface (surface along arrow Z2) of the first substrate 201 and the lower surface (surface along arrow Z1) of the second substrate 205 is filled with a sealing resin 70, similarly to the aforementioned first embodiment.

Due to the aforementioned structure, according to the second embodiment, the conductive pattern 207a provided on the upper surface (surface along arrow Z2) side of the second substrate 205 is electrically connected to the gate electrode G1a of the first switch element 11a through the columnar conductor 207k, the conductive pattern 207b, the bonding layer 45, the conductive pattern 203d of the first substrate 201, the columnar conductor 203f, the conductive pattern 203a, and the bump 42. Therefore, the conductive pattern 207a constitutes a control terminal 51a (see Fig. 1) into which a control signal for switching the first switch element 11a is input.

The conductive pattern 207c provided on the upper surface (surface along arrow Z2) side of the second substrate 205 is electrically connected to the drain electrode D1a of the first switch element 11a through the columnar conductor 2071, the conductive pattern 207d, and the bonding layer 41. Therefore, the conductive pattern 207c constitutes an input terminal 53 (see Fig. 1) connected to a P-electrode (+V) of an unshown direct-current power supply. Furthermore, the conductive pattern 207e of the second substrate 205 is electrically connected to the source electrode S2a of the second switch element 12a through the columnar conductor 207m, the conductive pattern 207f, and the bumps 44. Therefore, the conductive pattern 207e constitutes an input terminal 54 (see Fig. 1) connected to an N-electrode (-V) of the unshown direct-current power supply.

The conductive pattern 207g provided on the upper surface (surface along arrow Z2) side of the second substrate 205 is connected to the gate electrode G2a of the second switch element 12a through the columnar conductor 207n, the conductive pattern 207h, and the bump 44. Therefore, the conductive pattern 207g constitutes a control terminal 52a (see Fig. 1) into which a control signal for switching the second switch element 12a is input. Furthermore, the conductive pattern 207i of the second substrate 205 is electrically connected to the source electrode S1a of the first switch element 11a and the drain electrode D2a of the second switch element 12a through the columnar conductor 207o, the conductive pattern 207j, the bonding layer 45, the conductive pattern 203e of the first substrate 201, the columnar conductor 203g, the conductive pattern 203b, and the bonding layer 43. Therefore, the conductive pattern 207i constitutes a U-phase output terminal 55a (see Fig. 1) connected to an unshown motor or the like.

Next, a manufacturing process for the power module 200a according to the second embodiment is described with reference to Figs. 8 to 16.

First, the substrate 201 provided with the conductive patterns 203a to 203c, the two insulating plates 204, and the two conductive patterns 203d and 203e on the upper surface side (along arrow Z2) and lower surface side (along arrow Z1) of the insulating plate 202 is prepared, as shown in Figs. 10 and 11. Then, the upper surfaces (surfaces along arrow Z2) of the conductive patterns 203a and 203b of the first substrate 201 and the gate electrode G1a and the source electrode S1a on the rear surface side of the first switch element 11a, respectively, are bonded to each other through the bumps 42 made of solder or the like, as shown in Fig. 12.

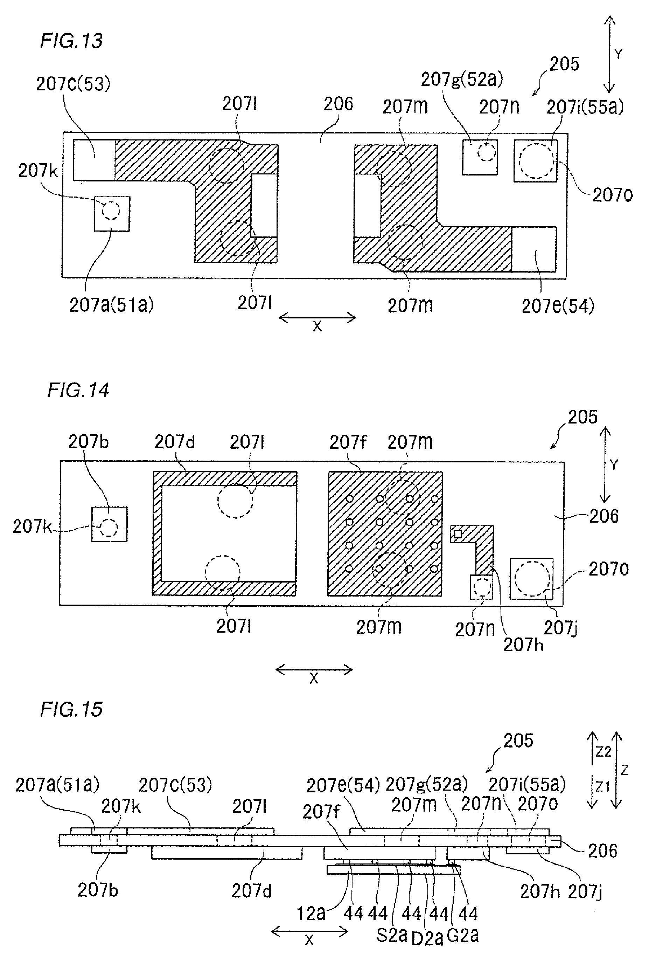

Then, the second substrate 205 provided with the ten conductive patterns 207a to 207j on the upper surface side (along arrow Z2) and lower surface side (along arrow Z1) of the insulating plate 206 is prepared, as shown in Figs. 13 and 14. Then, the lower surfaces (surfaces along arrow Z1) of the conductive patterns 207f and 207h of the second substrate 205 and the source electrode S2a and the gate electrode G2a on the rear surface side of the second switch element 12a, respectively, are bonded to each other through the bumps 44, as shown in Fig. 15.

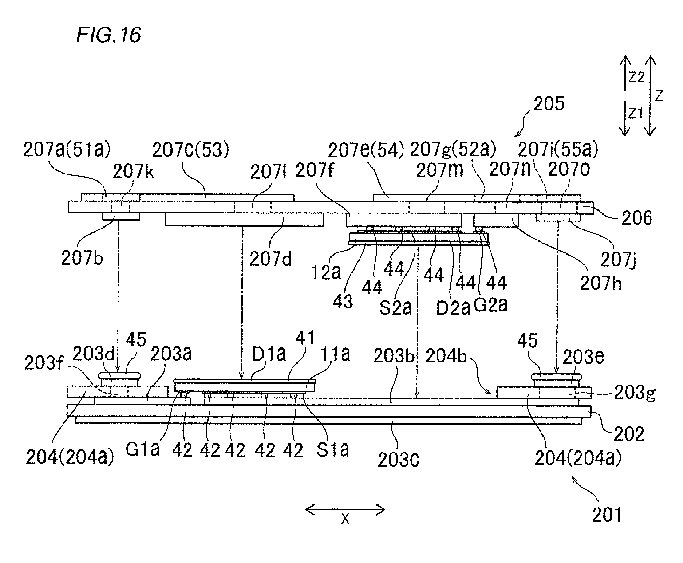

Then, the upper surface (surface along arrow Z2) of the first substrate 201 bonded with the first switch element 11a and the lower surface (surface along arrow Z1) of the second substrate 205 bonded with the second switch element 12a are bonded to each other in a state where the same are opposed to each other, as shown in Fig. 16. Specifically, the upper surfaces of the conductive patterns 203d and 203e provided on the upper surfaces of the insulating plates 204 (protruding portions 204a) protruding upward (along arrow Z2) from the upper surface of the first substrate 201 in the vicinity of both ends of the first substrate 201 in the direction X and the lower surfaces of the conductive patterns 207b and 207j provided on the lower surface of the second substrate 205 in the vicinity of both ends of the second substrate 205 in the direction X, respectively, are bonded to each other through the bonding layers 45 made of solder or the like.

At this time, the drain electrode D1a of the first switch element 11a bonded to the upper surface (surface along arrow Z2) of the first substrate 201 and the lower surface (surface along arrow Z1) of the conductive pattern 207d of the second substrate 205 are bonded to each other through the bonding layer 41 made of solder or the like. Furthermore, the drain electrode D2a of the second switch element 12a mounted on the lower surface of the second substrate 205 and the upper surface of the conductive pattern 203b of the first substrate 201 are bonded to each other through the bonding layer 43.

At this time, the space between the upper surface (surface along arrow Z2) of the first substrate 201 and the lower surface (surface along arrow Z1) of the second substrate 205 is filled with the sealing resin 70, as shown in Fig. 8. Furthermore, the snubber capacitor 10a is bonded to the upper surfaces of the conductive patterns 207c and 207e of the second substrate 205 through the bonding materials 60.

In the aforementioned bonding process employing the bonding layers 41, 43, and 45, the bumps 42 and 44, and the bonding materials 60 made of solder or the like, a solder resist is preferably applied to prescribed areas (see portions shown by diagonal lines in Figs. 11, 13, and 14, for example) in order to suppress spread of solder to unnecessary portions. Furthermore, in the aforementioned process for bonding the first substrate 201 and the second substrate 205 to each other through the bonding materials 45, high temperature solder can be employed for the bumps 42 (44) and low temperature solder can be employed for the bonding layers 45 in order to suppress melting of the bumps 42 (44) for bonding the first substrate 201 (second substrate 205) and the first switch element 11a (second switch element 12a) to each other.

According to the second embodiment, as hereinabove described, the conductive patterns 207c and 207e are provided on the upper surface (surface along arrow Z2) of the second substrate 205, and the conductive patterns 207d and 207f electrically connected to the conductive patterns 207c and 207e, respectively, are provided on the lower surface (surface along arrow Z1) of the second substrate 205. Furthermore, the upper surfaces of the conductive patterns 207c and 207e are connected to one electrode C1a and the other electrode C2a of the snubber capacitor 10a, respectively, and the lower surfaces of the conductive patterns 207d and 207f are connected to the drain electrode D1a of the first switch element 11a and the source electrode D2a of the second switch element 12a, respectively. Thus, conduction paths between the drain electrode D1a of the first switch element 11a and one electrode C1a of the snubber capacitor 10a and between the source electrode S2a of the second switch element 12a and the other electrode C2a of the snubber capacitor 10a can be easily reduced in length with the second substrate 205 including the conductive patterns 207c to 207f.

According to the second embodiment, as hereinabove described, the conductive pattern 207g is provided on the upper surface (surface along arrow Z2) side of the second substrate 205, and the conductive pattern 207h electrically connected to the conductive pattern 207g is provided on the lower surface (surface along arrow Z2) side of the second substrate 205. Furthermore, the conductive pattern 207h and the gate electrode G1a on the rear surface side of the second switch element 12a are connected to each other, and the conductive pattern 207g constitutes the control terminal 52a. Thus, the gate electrode G2a of the second switch element 12a and the control terminal 52a can be easily connected to each other, unlike the case where the gate electrode G2a of the second switch element 12a and the control terminal 52a into which the control signal is externally input are connected to each other by a wire or the like.

According to the second embodiment, the conductive patterns 207c and 207e provided on the upper surface (surface along arrow Z2) side of the second substrate 205 connected to the snubber capacitor 10a constitute the input terminals 53 and 54. Thus, the input terminals 53 and 54 can be easily connected to the unshown direct-current power supply, utilizing a region on the upper surface side of the second substrate 205.

According to the second embodiment, as hereinabove described, the recess portion 204b configured to arrange the first switch element 11a and the second switch element 12a and the protruding portions 204a (insulating plates 204) adjacent to the recess portion 204b are provided on the upper surface (surface along arrow Z2) side of the first substrate 201 arranged to be opposed to the lower surface (surface along arrow Z1) of the second substrate 205. Furthermore, the conductive patterns 203d and 203e provided on the protruding portions 204a (insulating plates 204) of the first substrate 201 and the lower surfaces of the conductive patterns 207b and 207j of the second substrate 205, respectively, are bonded to each other. Thus, the first switch element 11a and the second switch element 12a can be easily arranged between the upper surface of the first substrate 201 and the lower surface of the second substrate 205, utilizing the space constituted by the recess portion 204b of the first substrate 201. In addition, the protruding portions 204a provided in the first substrate 210 can stably support the second substrate 205 from below.

### (Third Embodiment)

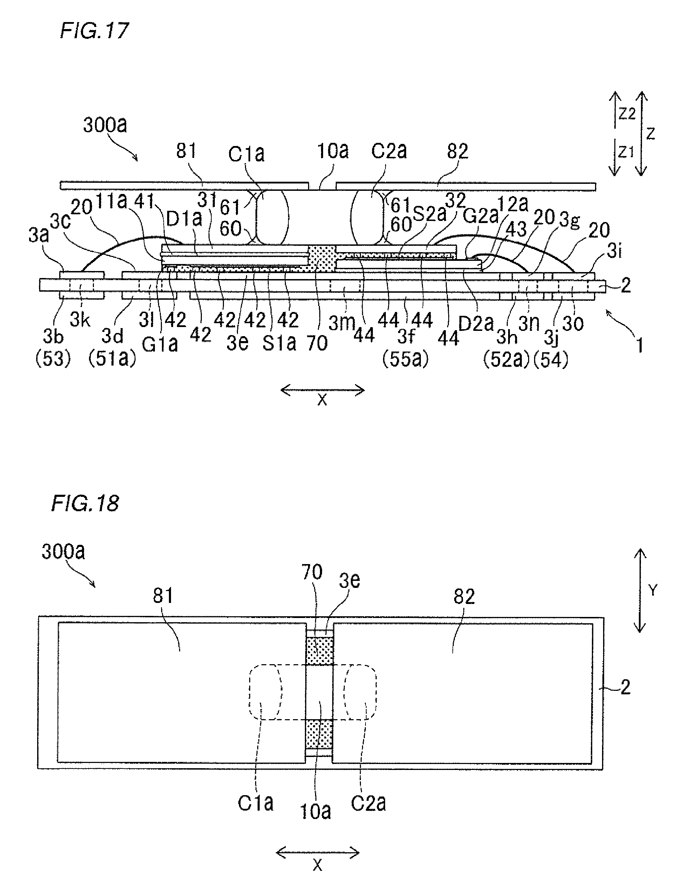

The structure of a power module 300a according to a third embodiment is now described with reference to Figs. 17 and 18. In this third embodiment, an example of providing heat radiating plates 81 and 82 having a heat radiating function on the upper surface side of a snubber capacitor 10a is described unlike the aforementioned first embodiment in which nothing is provided on the upper surface side (side along arrow Z2) of the snubber capacitor 10a. The power module 300a is an example of the "power converter" in the present invention. The heat radiating plates 81 and 82 are examples of the "heat radiating member" in the present invention.

The power module 200a according to the third embodiment performs U-phase power conversion in a three-phase inverter device. In other words, also according to this third embodiment, two power modules (power modules performing V-phase and W-phase power conversion) having substantially the same structure as the power module 300a are provided separately from the power module 300a, similarly to the aforementioned first embodiment. Only the power module 300a performing U-phase power conversion is described below for simplification.

As shown in Figs. 17 and 18, the power module 300a includes a substrate 1, two switch elements (a first switch element 11a and a second switch element 12a), two connection conductors 31 and 32, the snubber capacitor 10a, and the two heat radiating plates 81 and 82. The heat radiating plates 81 and 82 each are made of a conductor of metal such as copper excellent in thermal conductivity in the form of a flat plate.

According to the third embodiment, the heat radiating plates 81 and 82 are arranged on the upper surface side (side along arrow Z2) of the snubber capacitor 10a in correspondence to the connection conductors 31 and 32 arranged to be held between the snubber capacitor 10a and the first switch element 11a and between the snubber capacitor 10a and the second switch element 12a, respectively. Specifically, the lower surface (surface along arrow Z1) of the heat radiating member 81 and the upper surface (surface along arrow Z2) of one electrode C1a of the snubber capacitor 10a are bonded to each other through a bonding material 61 made of a conductive adhesive such as solder or conductive paste (silver paste, for example). Furthermore, the lower surface of the heat radiating plate 82 and the upper surface of the other electrode C2a of the snubber capacitor 10a are bonded to each other through a bonding material 61.

The remaining structure of the third embodiment is similar to that of the aforementioned first embodiment.

According to the third embodiment, as hereinabove described, the heat radiating members 81 and 82 are provided on the side (side along arrow Z2) of the snubber capacitor 10a opposite to the connection conductors 31 and 32. Thus, the heat radiating members 81 and 81 can easily radiate heat generated from the snubber capacitor 10a.

### (Fourth Embodiment)

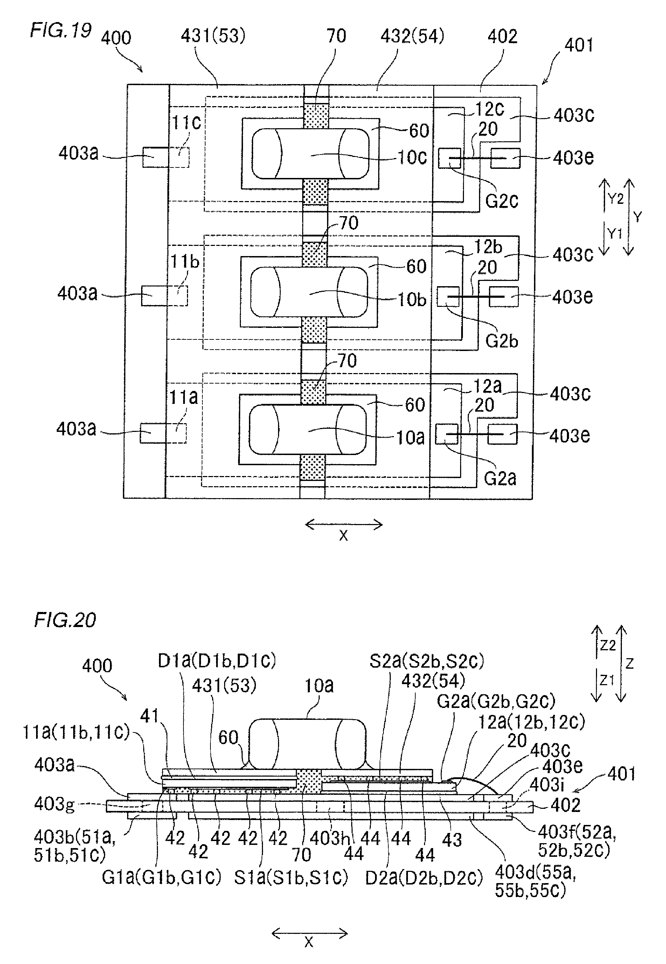

The structure of a power module 400 according to a fourth embodiment is now described with reference to Figs. 19 and 20. In this fourth embodiment, an example of performing all of U-phase power conversion, V-phase power conversion, and W-phase power conversion by a single device (power module (three-phase inverter device) 400) is described unlike the aforementioned first embodiment in which U-phase, V-phase, and W-phase power conversion is performed by the three devices (power modules 100a to 100c) provided separately from each other. The power module 400 is an example of the "power converter" in the present invention.

As shown in Figs. 19 and 20, the power module 400 includes a substrate 401, six switch elements (first switch elements 11a to 11c and second switch elements 12a to 12c), two connection conductors 431 and 432, and three snubber capacitors 10a to 10c. The substrate 401 is an example of the "first substrate" in the present invention.

The substrate 401 is configured to include an insulating plate 402 in the form of a flat plate, nine conductive patterns (three conductive patterns 403a, three conductive patterns 403b, and three conductive patterns 403c) provided on the upper surface (surface along arrow Z2) of the insulating plate 402, and nine conductive patterns (three conductive patterns 403d, three conductive patterns 403e, and three conductive patterns 403f) provided on the lower surface (surface along arrow Z1) of the insulating plate 402. The conductive patterns 403a, 403b, and 403c and the conductive patterns 403d, 403e, and 403f are electrically connected to each other through columnar conductors 403g, 403h, and 403i provided to pass through the insulting plate 402 from the upper surface to the lower surface, respectively. The three conductive patterns 403c are examples of the "first conductive pattern" in the present invention. The three conductive patterns 403a are examples of the "second conductive pattern" in the present invention, and the three conductive patterns 403b are examples of the "third conductive pattern" in the present invention.

As shown in Figs. 19 and 20, the two switch elements (the first switch element 11a and the second switch element 12a) configured to perform U-phase power conversion are aligned in a direction X on the upper surfaces of the conductive patterns 403a and 403c provided in the vicinity of an end along arrow Y1 (see Fig. 19) of the upper surface (surface along arrow Z2) of the substrate 401. These two switch elements (the first switch element 11a and the second switch element 12a) are arranged such that the front surfaces and the rear surfaces thereof are oppositely oriented to each other, similarly to the aforementioned first embodiment. In other words, a gate electrode G1a on the rear surface side of the first switch element 11a is bonded to the upper surface of the conductive pattern 403a of the substrate 401 through a bump 42. A source electrode S1a on the rear surface side of the first switch element 11a and a drain electrode D2a on the front surface side of the second switch element 12a are bonded to the upper surface of the conductive pattern 403c of the substrate 401 through bumps 42 and a bonding layer 44, respectively.

Similarly, the first switch element 11b (11c) and the second switch element 12b (12c) configured to perform V-phase (W-phase) power conversion are aligned in the direction X on the upper surfaces of the conductive patterns 403a and 403c provided in the vicinity of a central portion in a direction Y (in the vicinity of an end along arrow Y2) (see Fig. 19) of the upper surface (surface along arrow Z2) of the substrate 401. The first switch element 11b (11c) and the second switch element 12b (12c) are arranged such that the front surfaces and the rear surfaces thereof are oppositely oriented to each other. In other words, a gate electrode G1b (G1c) on the rear surface side of the first switch element 11b (11c) is bonded to the upper surface of the conductive pattern 403a of the substrate 401 through a bump 42. A source electrode S1b (S1c) on the rear surface side of the first switch element 11b (11c) and a drain electrode D2b (D2c) on the front surface side of the second switch element 12b (12c) are bonded to the upper surface of the conductive pattern 403c of the substrate 401 through bumps 42 and a bonding layer 44, respectively.

According to the fourth embodiment, the connection conductors 431 and 432 each are made of a conductor in the form of a flat plate extending in the direction Y, as shown in Fig. 19. Thus, the connection conductors 431 and 432 are arranged across the three first switch elements 11a to 11c and the three second switch elements 12a to 12c in common, respectively. In other words, respective drain electrodes D1a to D1c of the three first switch elements 11a to 11c are bonded to the lower surface (surface along arrow Z1) of the connection conductor 431 through bonding layers 41, as shown in Fig. 20. Respective source electrodes S2a to S2c on the rear surface sides of the three second switch elements 12a to 12c are bonded to the lower surface of the connection conductor 432 through bumps 44.

According to the fourth embodiment, the connection conductors 431 and 432 are also arranged across the three snubber capacitors 10a to 10c in common in addition to the aforementioned six switch elements (the three first switch elements 11a to 11c and the three second switch elements 12a to 12c). The snubber capacitors 10a, 10b, and 10c are arranged across the upper surfaces (surfaces along arrow Z2) of the two connection conductors 431 and 432 in correspondence to the first switch element 11a and the second switch element 12a, the first switch element 11b and the second switch element 12b, and the first switch element 11c and the second switch element 12c, respectively. The snubber capacitors 10a to 10c are bonded to the upper surfaces of the connection conductors 431 and 432 through bonding materials 60.

As hereinabove described, according to the fourth embodiment, the connection conductors 431 and 432 are arranged to be held between the three first switch elements 11a to 11c and the three snubber capacitors 10a to 10c and between the three second switch elements 12a to 12c and the three snubber capacitors 10a to 10c. The connection conductors 431 and 432 are examples of the "first connection conductor" and the "second connection conductor" in the present invention, respectively.

Also according to this fourth embodiment, a region between the upper surface (surface along arrow Z2) of the substrate 401 and the lower surfaces (surfaces along arrow Z1) of the connection conductors 431 and 432 and a region between the upper surface of the substrate 401 and the lower surfaces of the snubber capacitors 10a to 10c are filled with sealing resins 70, similarly to the aforementioned first embodiment. Gate electrodes G2a to G2c of the second switch elements 12a to 12c are electrically connected to the respective upper surfaces of the three conductive patterns 403e of the substrate 401 through wires 20.

Due to the aforementioned structure, according to the fourth embodiment, the three respective conductive patterns 403b provided on the lower surface (surface along arrow Z1) side of the substrate 401 are electrically connected to the gate electrodes G1a to G1c of the first switch elements 11a to 11c through the columnar conductors 403g, the conductive patterns 403a, and the bumps 42, as shown in Fig. 20. Therefore, the three conductive patterns 403b constitute three control terminals 51a to 51c (see Fig. 1) into which control signals for switching the first switch elements 11a to 11c are input.

The three respective conductive patterns 403d provided on the lower surface (surface along arrow Z1) side of the substrate 401 are electrically connected to the source electrodes S1a to S1c of the first switch elements 11a to 11c through the columnar conductors 403h, the conductive patterns 403c, and the bumps 43 and are electrically connected to the drain electrodes D2a to D2c of the second switch elements 12a to 12c through the columnar conductors 403h, the conductive patterns 403c, and the bonding layers 43. Therefore, the three respective conductive patterns 403d constitute U-phase, V-phase, and W-phase output terminals 55a to 55c (see Fig. 1) connected to unshown motors or the like.

The three respective conductive patterns 403f provided on the lower surface (surface along arrow Z1) side of the substrate 401 are electrically connected to the gate electrodes G2a to G2c of the second switch elements 12a to 12c through the columnar conductors 403i, the conductive patterns 403e and the wires 20. Therefore, the three respective conductive patterns 403f constitute three control terminals 52a to 52c (see Fig. 1) into which control signals for switching the second switch elements 12a to 12c are input.

The connection conductor 431 is electrically connected to the drain electrodes D1a to D1c of the first switch elements 11a to 11c through the bonding layers 41, and the connection conductor 432 is electrically connected to the source electrodes S2a to S2c of the second switch elements 12a to 12c through the bumps 44. Therefore, the connection conductors 431 and 432 constitute an input terminal 53 (see Fig. 1) connected to a P-electrode (+V) of an unshown direct-current power supply and an input terminal 54 (see Fig. 1) connected to an N-electrode (-V) thereof, respectively.

According to the fourth embodiment, as hereinabove described, the single power module (three-phase inverter device) 400 is configured by connecting the three first switch elements 11a to 11c and the three second switch elements 12a to 12c to the three snubber capacitors 10a to 10c in parallel to each other. Thus, the number of components can be reduced unlike the case where a total of three power modules of a power module constituted by the first switch element 11a, the second switch element 12a, and the snubber capacitor 10a, a power module constituted by the first switch element 11b, the second switch element 12b, and the snubber capacitor 10b, and a power module constituted by the first switch element 11c, the second switch element 12c, and the snubber capacitor 10c are provided separately from each other (the case where the three-phase inverter device 100 (see Fig. 1) is constituted by the three power modules 100a to 100c provided separately from each other, as in the aforementioned first embodiment, for example), and hence the structure of the device can be simplified.

According to the fourth embodiment, the connection conductors 431 and 432 are arranged across the three first switch elements 11a to 11c, the three second switch elements 12a to 12c, and the three snubber capacitors 10a to 10c in common. Thus, the number of components can be reduced unlike the case where three respective connection conductors are provided separately for the first switch element 11a, the second switch element 12a, and the snubber capacitor 10a, for the first switch element 11b, the second switch element 12b, and the snubber capacitor 10b, and for the first switch element 11c, the second switch element 12c, and the snubber capacitor 10c, and hence the structure of the device can be simplified.

The embodiments disclosed this time must be considered as illustrative in all points and not restrictive. The range of the present invention is shown not by the above description of the embodiments but by the scope of claims for patent, and all modifications within the meaning and range equivalent to the scope of claims for patent are further included.

For example, while the example of applying the present invention to the three-phase inverter device (power converter) including the switch elements and the snubber capacitors has been shown in each of the aforementioned first to fourth embodiments, the present invention is also applicable to a power converter other than the three-phase inverter device, so far as the same includes switch elements and snubber capacitors.

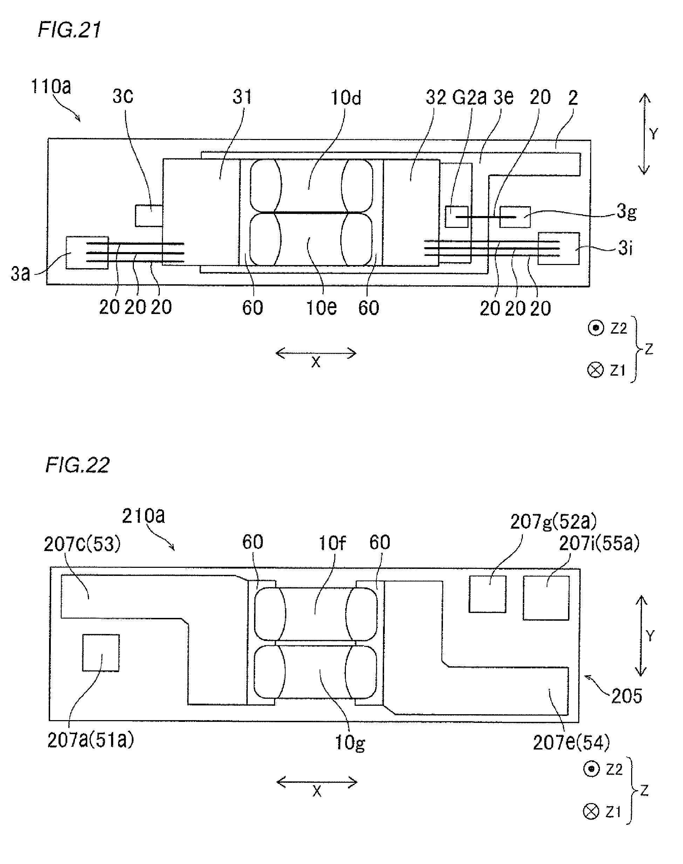

While the single snubber capacitor is provided in the single power module (power converter) in each of the aforementioned first and second embodiments, the present invention is not restricted to this. According to the present invention, two or more snubber capacitors may be provided in the single power module. As in a modification of the first embodiment shown in Fig. 21 (a modification of the second embodiment shown in Fig. 22), for example, two snubber capacitors 10d and 10e (10f and 10g) may be provided in a single power module 110a (210a). The power module 110a (210a) is an example of the "power converter" in the present invention.

According to the modification of the first embodiment shown in Fig. 21, the two snubber capacitors 10d and 10e are provided in the single power module 110a. These two snubber capacitors 10d and 10e are aligned in a direction Y across the upper surfaces (surfaces along arrow Z2) of two connection conductors 31 and 32. Also according to this modification shown in Fig. 21, the connection conductors 31 and 32 are arranged to be held between a first switch element 11a and the snubber capacitors 10d and 10e and between a second switch element 12a and the snubber capacitors 10d and 10e, respectively, similarly to the aforementioned first embodiment shown in Fig. 2.

Similarly, according to the modification of the second embodiment shown in Fig. 22, the two snubber capacitors 10f and 10g are provided in the single power module 210a. These two snubber capacitors 10f and 10g are aligned in a direction Y across the upper surfaces (surfaces along arrow Z2) of two conductive patterns 207c and 207e provided on the upper surface (surface along arrow Z2) side of a second substrate 205. Also according to this modification shown in Fig. 22, conductive patterns 207c and 207d of the second substrate 205 and a columnar conductor 2071 are arranged to be held between a first switch element 11a and the snubber capacitors 10f and 10g, similarly to the aforementioned second embodiment shown in Fig. 8. Furthermore, conductive patterns 207e and 207f of the second substrate 205 and a columnar conductor 207m are arranged to be held between a second switch element 12a and the snubber capacitors 10f and 10g.

According to the modification of the first embodiment shown in Fig. 21 (the modification of the second embodiment shown in Fig. 22), as hereinabove described, the single power module 110a (210a) is provided with the two snubber capacitors 10d and 10e (10f and 10g), whereby more surge voltage can be absorbed, as compared with the case where the single power module is provided with a single snubber capacitor (the case of the aforementioned first or second embodiment).

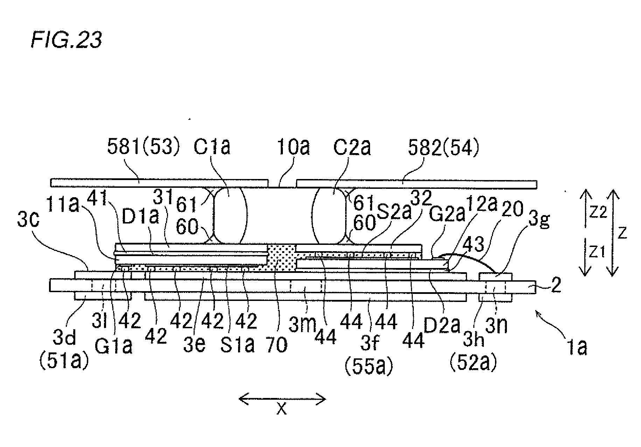

While the example of employing the conductive patterns 3b and 3j provided on the lower surface (surface along arrow 21) side of the substrate 1 as the input terminal 53 (see Fig. 1) connected to the P-electrode (+V) of the unshown direct-current power supply and the input terminal 54 (see Fig. 1) connected to the N-electrode (-V) thereof, respectively, has been shown in the aforementioned third embodiment, as shown in Fig. 17, the present invention is not restricted to this. According to the present invention, heat radiating plates 581 and 582 may be employed as the input terminals 53 and 54 (see Fig. 1), respectively, as in a modification of the third embodiment shown in Fig. 23. The heat radiating plates 581 and 582 are examples of the "heat radiating member" in the present invention.

According to the modification of the third embodiment shown in Fig. 23, the heat radiating plates 581 and 582 each are made of a conductor of metal such as copper excellent in thermal conductivity in the form of a flat plate, similarly to the aforementioned third embodiment. The heat radiating plate 581 is electrically connected to a drain electrode D1a of a first switch element 11a through a bonding material 61, one terminal C1a of a snubber capacitor 10a, a bonding material 60, a connection conductor 31, and a bonding layer 41. Thus, the heat radiating plate 581 constitutes an input terminal 53 (see Fig. 1) connected to a P-electrode (+V) of an unshown direct-current power supply. The heat radiating plate 582 is electrically connected to a source electrode S2a of a second switch element 12a through a bonding material 61, the other electrode C2a of the snubber capacitor 10a, a bonding material 60, a connection conductor 32, and bumps 44. Thus, the heat radiating plate 582 constitutes an input terminal 54 (see Fig. 1) connected to an N-electrode (-V) of the unshown direct-current power supply.

According to the modification of the third embodiment shown in Fig. 23, as hereinabove described, the heat radiating plates 581 and 582 are employed as the input terminals 53 and 54 (see Fig. 1), whereby conductive patterns (the aforementioned conductive patterns 3b and 3j according to the third embodiment shown in Fig. 17) dedicated for constituting the input terminals 53 and 54 may not be provided in a substrate 1a, and hence the structure of the device can be simplified.

While the example of making each of the heat radiating plates of a conductor of metal such as copper excellent in thermal conductivity in the form of a flat plate has been shown in the aforementioned third embodiment, the present invention is not restricted to this. According to the present invention, the heat radiating member may be made of a member other than metal, so far as the member is excellent in thermal conductivity.

While the MOSFET (field-effect transistor) is employed as each of the switch elements (power conversion semiconductor elements) in each of the aforementioned first to fourth embodiments, the present invention is not restricted to this. According to the present invention, another transistor such as an IGBT (insulated gate bipolar transistor) may be employed as each of the switch elements.

## Claims

1. A power converter (100, 100a, 100b, 100c, 110a, 200a, 210a, 300a, 400) comprising:
a switch element (11a, 11b, 11c, 12a, 12b, 12c) having an electrode (D1a, D1b, D1c, S1a, S1b, S1c, G1a, G1b, G1c, D2a, D2b, D2c, S2a, S2b, S2c, G2a, G2b, G2c);
a snubber capacitor (10a, 10b, 10c, 10d, 10e, 10f, 10g) connected to the electrode of the switch element; and
a connection conductor (31, 32, 207c, 207d, 207e, 207f, 2071, 207m, 431, 432) configured to connect the electrode of the switch element and the snubber capacitor to each other, wherein
at least a part of the connection conductor is arranged to be held between the snubber capacitor and the electrode of the switch element.

2. The power converter according to claim 1, wherein
the switch element includes a first switch element (11a, 11b, 11c) having a front surface side electrode (D1a, D1b, D1c) arranged on a side of the connection conductor and a second switch element (12a, 12b, 12c) having a rear surface side electrode (S2a, S2b, S2c, G2a, G2b, G2c) arranged on the side of the connection conductor, and
at least the part of the connection conductor is arranged to be held between the snubber capacitor and the front surface side electrode of the first switch element or between the snubber capacitor and the rear surface side electrode of the second switch element.

3. The power converter according to claim 2, wherein
the connection conductor includes a first connection conductor (31, 207c, 207d, 2071, 431) configured to connect the snubber capacitor and the front surface side electrode of the first switch element to each other and a second connection conductor (32, 207e, 207f, 207m, 432) configured to connect the snubber capacitor and the rear surface side electrode of the second switch element to each other.

4. The power converter according to claim 2 or 3, further comprising a first substrate (1, 1a, 201, 401) mounted with the first switch element and the second switch element, wherein
a first conductive pattern (3e, 203b, 403c) configured to connect a rear surface side electrode of the first switch element and a front surface side electrode of the second switch element to each other is provided on a front surface of the first substrate.

5. The power converter according to any one of claims 1 to 4, wherein
the connection conductor is bonded to the snubber capacitor through a bonding material (60).

6. The power converter according to any one of claims 1 to 5, wherein
the connection conductor is employed in common for a plurality of the snubber capacitors.

7. The power converter according to claim 6, wherein
a three-phase inverter circuit (100) is configured by connecting three half-bridge circuits (101a, 101b, 101c) each including the switch element to the plurality of snubber capacitors in parallel to each other, and
the connection conductor is arranged across the switch element of each of the three half-bridge circuits and the plurality of snubber capacitors in common.

8. The power converter according to any one of claims 1 to 7, further comprising a heat radiating member (81, 82, 581, 582) arranged on a side of the snubber capacitor opposite to a side connected with the connection conductor.

9. The power converter according to any one of claims 1 to 8, further comprising a first substrate (1, 1a, 201, 401) mounted with the switch element on a front surface, wherein
a region between the front surface of the first substrate and the connection conductor is filled with a sealing resin (70).

10. The power converter according to any one of claims 1 to 9, wherein
the connection conductor is made of a plate-like conductor,
the snubber capacitor is connected to a front surface of the connection conductor made of the plate-like conductor, and
the electrode of the switch element is connected to a rear surface of the connection conductor made of the plate-like conductor.

11. The power converter according to any one of claims 1 to 10, further comprising a first substrate (1, 1a, 401) mounted with the switch element on a front surface, wherein
at least one conductive pattern (3b, 3d, 3f, 3h, 3j, 403b, 403d, 403f) electrically connected to the switch element, constituting a terminal (51a, 51b, 51c, 52a, 52b, 52c, 53, 54, 55a, 55b, 55c) is provided on a rear surface of the first substrate.

12. The power converter according to claim 11, wherein
the electrode of the switch element includes:
a first electrode (D1a, D1b, D1c) provided on a front surface side, electrically connected to the snubber capacitor, and
a second electrode (G1a, G1b, G1c) for control provided on a rear surface side, electrically connected to an external portion,
the first substrate includes a second conductive pattern (3c, 403a) provided on the front surface and a third conductive pattern (3d, 403b) electrically connected to the second conductive pattern, provided on the rear surface,
the second conductive pattern of the first substrate is connected to the second electrode for control provided on the rear surface side of the switch element, and
the third conductive pattern of the first substrate constitutes a first control terminal (51a, 51b, 51c) connected to an external portion.

13. The power converter according to claim 12, wherein
the first substrate includes a fourth conductive pattern (3a, 3i) provided on the front surface and a fifth conductive pattern (3b, 3j) electrically connected to the fourth conductive pattern, provided on the rear surface in addition to the second conductive pattern and the third conductive pattern,
the fourth conductive pattern of the first substrate is connected to the connection conductor arranged to be held between the snubber capacitor and the electrode of the switch element, and
the fifth conductive pattern of the first substrate constitutes a terminal (53, 54).

14. The power converter according to any one of claims 1 to 11, further comprising a second substrate (205) configured to include the connection conductor, wherein
the second substrate includes a sixth conductive pattern (207c, 207e) provided on a front surface and a seventh conductive pattern (207d, 207f) electrically connected to the sixth conductive pattern, provided on a rear surface,
the seventh conductive pattern of the second substrate is connected to the electrode of the switch element, and
the sixth conductive pattern of the second substrate is connected to the snubber capacitor.

15. The power converter according to claim 14, wherein
the electrode of the switch element includes a first electrode (D2a, D2b, D2c) electrically connected to the snubber capacitor and a second electrode (G2a, G2b, G2c) for control electrically connected to an external portion,
the second substrate further includes an eighth conductive pattern (207g) provided on the front surface and a ninth conductive pattern (207h) electrically connected to the eighth conductive pattern, provided on the rear surface in addition to the sixth conductive pattern and the seventh conductive pattern,
the seventh conductive pattern of the second substrate is connected to the first electrode of the switch element,
the ninth conductive pattern of the second substrate is connected to the second electrode for control of the switch element, and
the eighth conductive pattern of the second substrate constitutes a second control terminal (52a) connected to an external portion.

16. The power converter according to claim 14 or 15, wherein
the sixth conductive pattern of the second substrate constitutes a terminal (53, 54).

17. The power converter according to any one of claims 14 to 16, further comprising a first substrate (201) mounted with the switch element, wherein
the first substrate is arranged such that a front surface of the first substrate is opposed to the rear surface of the second substrate and includes a recess portion (204b) configured to mount the switch element and a protruding portion (204a) adjacent to the recess portion, and
the protruding portion of the first substrate is bonded to the rear surface of the second substrate.

18. The power converter according to any one of claims 1 to 17, wherein
the switch element includes a power conversion semiconductor element (11a, 11b, 11c, 12a, 12b, 12c), and
at least the part of the connection conductor is arranged to be held between the snubber capacitor and the electrode of the power conversion semiconductor element.

19. A method for manufacturing a power converter (100, 100a, 100b, 100c, 110a, 200a, 210a, 300a, 400) comprising a switch element (11a, 11b, 11c, 12a, 12b, 12c) having an electrode (D1a, D1b, D1c, S1a, S1b, S1c, G1a, G1b, G1c, D2a, D2b, D2c, S2a, S2b, S2c, G2a, G2b, G2c) and a snubber capacitor (10a, 10b, 10c, 10d, 10e, 10f, 10g), comprising steps of:
connecting the electrode of the switch element to a rear surface side of a connection conductor (31, 32, 207c, 207d, 207e, 207f, 2071, 207m, 431, 432); and
connecting the snubber capacitor to a front surface side of the connection conductor such that at least a part of the connection conductor is held between the snubber capacitor and the electrode of the switch element.

20. The method for manufacturing a power converter according to claim 19, wherein
the switch element includes a first switch element (11a, 11b, 11c) having a front surface side electrode (D1a, D1b, D1c) arranged on a side of the connection conductor and a second switch element (12a, 12b, 12c) having a rear surface side electrode (S2a, S2b, S2c, G2a, G2b, G2c) arranged on the side of the connection conductor,
the method for manufacturing a power converter further comprising a step of bonding a rear surface side of the first switch element to a front surface of a first substrate (201), wherein
the step of connecting the electrode of the switch element includes steps of:
bonding a rear surface side of the second switch element to a rear surface of a second substrate (205) including the connection conductor to connect the rear surface side electrode of the second switch element to the rear surface side of the connection conductor of the second substrate, and
bonding the front surface of the first substrate to which the rear surface side of the first switch element is bonded and the rear surface of the second substrate to which the rear surface side of the second switch is bonded to each other in a state where the front surface of the first substrate and the rear surface of the second substrate are opposed to each other to connect the front surface side electrode of the first switch element to the rear surface side of the connection conductor of the second substrate.
